(19) Europäisches Patentamt
European Patent Office
Office européen des brevets

(11) **EP 3 602 092 B1**

(12) **EUROPEAN PATENT SPECIFICATION**

(45) Date of publication and mention
of the grant of the patent:
**10.08.2022 Bulletin 2022/32**

(21) Application number: **18716345.6**

(22) Date of filing: **19.03.2018**

(51) International Patent Classification (IPC):
**G01R 33/032** *(2006.01)*    **G01R 15/24** *(2006.01)*

(52) Cooperative Patent Classification (CPC):
**G01R 33/0325; G01R 15/243**

(86) International application number:
**PCT/IB2018/051820**

(87) International publication number:
**WO 2018/172909 (27.09.2018 Gazette 2018/39)**

(54) **A VOLTAGE MEASURING SYSTEM WITH AN OPTICAL FIBRE CABLE**

SPANNUNGSMESSSYSTEM MIT EINEM FASEROPTISCHEN KABEL

SYSTÈME DE MESURE DE TENSION ÉLECTRIQUE À CÂBLE À FIBRE OPTIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **21.03.2017 IT 201700031165**

(43) Date of publication of application:
**05.02.2020 Bulletin 2020/06**

(73) Proprietor: **Cohaerentia S.r.l.**
**20133 Milano (IT)**

(72) Inventors:
• **MARTINELLI, Mario**
**20097 San Donato Milanese (MI) (IT)**
• **FERRARIO, Maddalena**
**20050 Verano Brianza (MB) (IT)**
• **BRUNERO, Marco**
**28100 Novara (NO) (IT)**

(74) Representative: **Gatti, Enrico**
**Giambrocono & C. S.p.A.**
**Via E. Zambianchi, 3**
**24121 Bergamo (IT)**

(56) References cited:
**US-A- 5 493 220     US-A- 5 631 559
US-A- 5 994 898**

• **KUMADA AKIKO ET AL: "Kerr effect in gas and
its application to noncontact measurement of
electric field", JOURNAL OF APPLIED PHYSICS,
AMERICAN INSTITUTE OF PHYSICS, US, vol. 92,
no. 5, 1 September 2002 (2002-09-01), pages
2875-2879, XP012057205, ISSN: 0021-8979, DOI:
10.1063/1.1499216**

**Description**

The present invention refers to a voltage measuring system with an optical fibre cable, in particular based on the Kerr electro-optic effect, in which the optical fibre constitutes the voltage sensor.

The difficulty in producing a fibre sensor for measuring voltage lies mainly in the difficulty of producing an "intrinsic" type sensor, where the measurement is performed directly by means of the optical fibre without the addition of intermediate transduction devices unlike those of "extrinsic" type in which the measurement is performed with the aid of external devices.

Examples of "intrinsic" optical fibre current sensors exist (all based on the Faraday effect) whereas optical fibre voltage sensors are typically of "extrinsic" type.

Among these sensors the most widespread are those based on an electro-optic effect (Pockels) induced in a crystal external to the optical fibre to modify the phase or the state of polarization of the light conveyed by the fibre.

The Pockels cells are costly extrinsic solutions and their long-term stability is vulnerable both to variations in temperature and the presence of vibrations or mechanical shocks.

Alternatively there are solutions based on the piezoelectric effect of a material (usually of cylindrical shape) on which the optical fibre is integrally wound.

The piezoelectric effect causes a deformation of the fibre which is detected as phase modulation. The use of "extrinsic" solutions, based on the effect induced in electro-optic or piezoelectric materials, is due to the fact that in itself the fibre, being an amorphous material, does not present electro-optic linear effects.

Interferometric systems combined with piezoelectric materials are potentially a solution with high sensitivity and low cost but, in addition to being affected in general by temperature and vibrations, they require stabilization of the state of polarization of the optical signal. This is typically guaranteed by using special fibres (spun, poled or PM), which require complicated and costly work processes, or very short sections of standard fibre which, however, require the entire interrogation system to be near the measurement point and therefore cannot be remote-controlled.

A solution recently much investigated is that of the Fiber Bragg Grating filters combined with piezoelectric materials which offer the advantage of multi-point measurements along the same fibre (multiplexing) and immunity to spurious attenuations along the fibre. However, the greatest criticalities of this technology are the drifts induced by the temperature which influences both the piezoelectric material and the response of the filters, and the cost of the solution, which continues to be high.

In the presence of an electrical field, the conventional optical fibres present the Kerr effect, in particular the electro-optic type Kerr effect.

The electro-optic Kerr effect is a non-linear effect which involves third order susceptibility in which the refraction index $n$ of the material varies proportionally to the square modulus of the electric field applied, i.e. to the intensity of

$$\Delta n = \frac{|E|^2}{2\eta} \left( 2bn_{2K} - n_{2E} \right)$$

the field:

with $n_{2K} \cong 2{,}3 \cdot 10^{-20}$ m$^2$/W and $n2E \cong 0{,}5 \cdot 10^{-20}$ m$^2$/W, $\eta = 377\Omega$ and b between 1 and 1/3 according to the alignment of the field E with respect to the state of polarization of the optical signal which propagates in the material. Typically the Kerr effect in optical fibre is induced by the high intensity of an optical pumping field propagating in fibre but the same effect can occur also with electric fields applied externally, for example, by positioning the fibre between two conducting plates. This way of inducing the Kerr effect has not been widely studied since the Kerr coefficient, called $n_2$, is so small
that it is typically assumed that the optical fibre is insensitive to electric fields.

Devices using the Kerr effect are disclosed in the documents US 5,994,898, US 5,631,559, and US 5,493,220.

The object of the present invention is to provide a voltage measurement system with optical fibre cable, based on the electro-optic Kerr effect, which is able to take measurements in a reliable and accurate manner.

A further object is to provide a voltage measurement system with optical fibre cable, based on the Kerr effect, which is safe for the operator.

A further object is to provide a voltage measuring system with an optical fibre cable which can be easily remote-controlled.

A further object is to provide a voltage measuring system with optical fibre cable which uses standard type optical fibres.

A further object is to provide a voltage measuring system with optical fibre cable, based on the electro-optic Kerr effect, which is simple to produce.

A further object is to provide a voltage measuring system with optical fibre cable, based on the electro-optic Kerr effect, which is independent of the random variations in the state of polarization (SOP) of the optical signal.

A further object is to provide a measuring system with optical fibre cable for voltage and also for other measurements.

A further object is to provide a system which is furthermore immune both from local temperature variations and mechanical vibrations.

According to the present invention, said objects and others are achieved by a voltage measuring system and a method with optical fibre cable according to the attached claims.

This solution has various advantages compared to the solutions in the known art.

Compared to the conventional sensors (voltage transformers), the advantage is mainly relative to the electrical insulation and to the electromagnetic immunity guaranteed by the optical fibre systems and the possibility of remote-controlling the demodulation system away from the specific measuring point, thus also allowing measurements in hostile environments (high temperature, humidity, etc.). The optical fibre sensors further guarantee an acquisition band and a dynamic measurement interval typically greater than the conventional voltage transformers, making it possible to diagnose also fast transients or pulse phenomena indicative of system malfunctions.

The intrinsic sensor solution proposed is based in particular on standard optical fibres and on interferometric measurement, or phase shift $\Delta\phi$ induced due to Kerr effect by the voltage applied, independent of the state of polarization of the optical signal and immune from both local temperature variations and mechanical vibrations. A solution which is robust, highly sensitive, low cost, easy to remote-control and combinable also with multiplexing schemes is therefore guaranteed.

The present solution permits measurement of the Kerr effect independent of the random variations in the state of polarization (SOP) of the optical signal also without recourse to special fibres (spun fibres with low birefringence, PM fibres).

It allows, if necessary, simultaneous measurement of the voltage applied to the cable and the temperature of the cable itself, allowing dependence of the Kerr effect on temperature variations to be compensated in real time.

It also allows, if necessary, measurement of the phase modulation induced by the Kerr effect immune from any mechanical vibrations on the cable, due to the presence of a reference fibre in the cable itself.

A voltage measurement independent of the state of polarization of the optical signal is therefore obtained; if necessary independent of temperature variations; and if necessary the noise induced by external vibrations can be compensated.

The present solution is particularly interesting, for example, for monitoring transformers and high voltage lines and power supply systems for industrial plants and processes.

Furthermore, the same sensor can be integrated with conventional electric sensors (for example chemical, pH, pressure sensors, etc.) to locally convert the electric signal into an optical signal and then guarantee easy remote control on optical fibre, with high quality of the signal transmitted.

The applications for simultaneous measurement of voltage and current are equally important. The voltage sensor proposed combined with an optical fibre current sensor, which exploits the Faraday effect, for example, offers the possibility of producing an "intrinsic" type power meter made completely of optical fibre. In fact, the voltage V(t) applied is alternated with pulsation $\omega(t)$, the phase modulation induced by the Kerr effect has a pulsation $2\omega(t)$, since it is proportional to the square of the electronic field. The voltage and current information, since they are spectrally separate, $\omega$ and $2\omega$ respectively, can therefore be extracted simultaneously using the same sensor fibre and the same coherent demodulation unit. The characteristics and advantages of the present invention will be evident from the following detailed description of a practical embodiment thereof, illustrated by way of non-limiting example in the accompanying drawings in which:

figure 1a shows schematically a voltage measuring system with optical fibre cable, seen laterally and figure 1b seen in section, according to a first embodiment of the present invention;
figure 2 shows schematically a voltage measuring system with optical fibre cable, according to a second embodiment of the present invention;
figure 3 shows schematically a voltage measuring system with optical fibre cable, according to a third embodiment of the present invention;

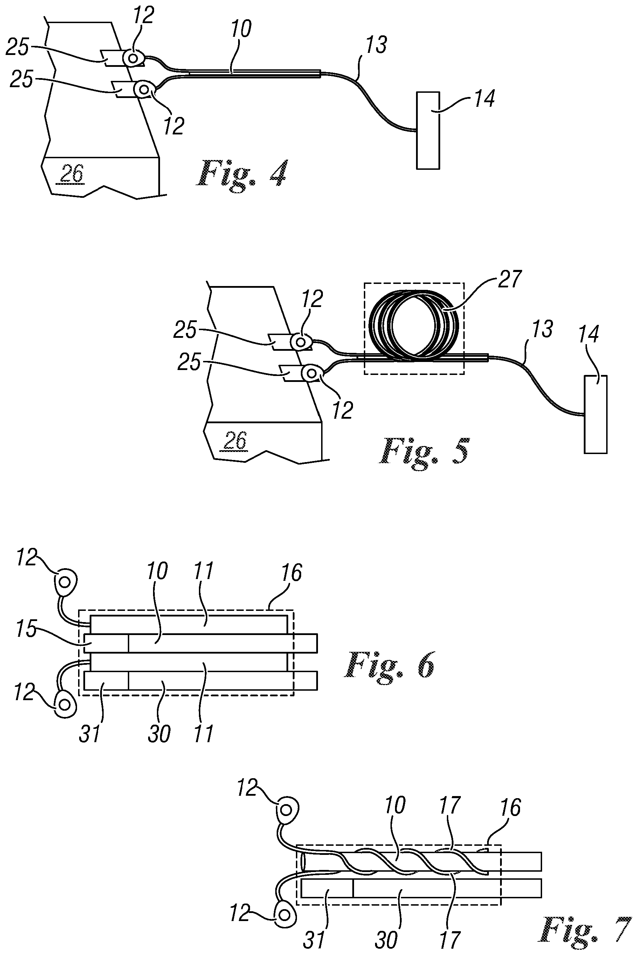

figure 4 shows schematically a voltage measuring system with optical fibre cable, applied to terminals for the voltage measurement thereof, according to the present invention;
figure 5 shows schematically a voltage measuring system with optical fibre cable, applied to terminals for the voltage measurement thereof, with part of the fibre wound, according to the present invention;
figure 6 shows schematically a voltage measuring system with optical fibre cable, with a reference optical fibre cable, according to the first embodiment of the present invention;

figure 7 shows schematically a voltage measuring system with optical fibre cable, with a reference optical fibre cable, according to the second embodiment of the present invention;

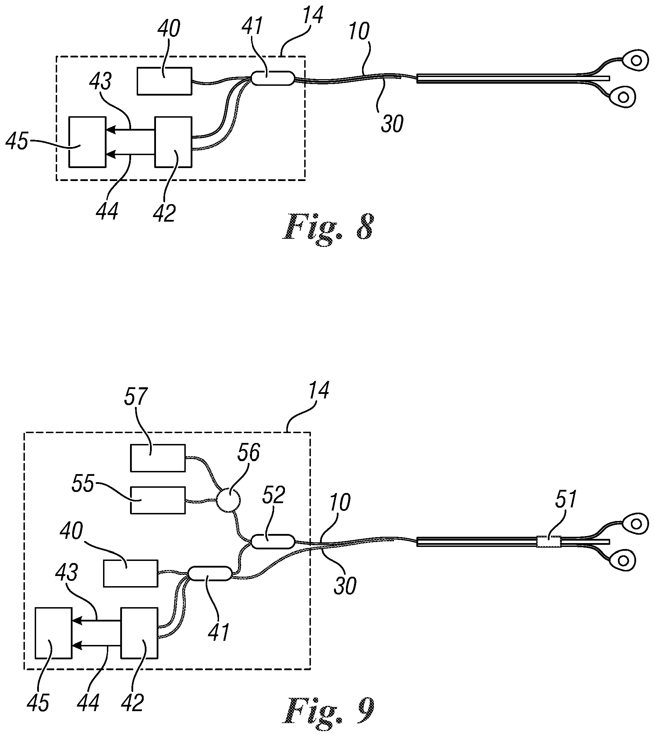

figure 8 shows schematically a voltage measuring system with optical fibre cable, including transmitter/receiver, according to the present invention;
figure 9 shows schematically a voltage measuring system with optical fibre cable, including transmitter/receiver, according to an alternative embodiment of the present invention.

Referring to the attached figures, the voltage measuring system with optical fibre cable, according to the present invention, comprises an optical fibre cable 10, with two electrically conducting cables 11 running alongside, for example made of copper, to which two bushes 12 are connected. The bushes 12 are applied to respective ends 25 of an electric circuit 26, for measuring the voltage thereof. The two cables 11 can also have other forms, for example flat or concave metal bars, in order to contain the optical fibre cable 10 within them.

The optical fibre cable 10 is connected on one side, by means of an optical fibre cable 13, to an optical transmitter and receiver 14 whereas on the other side it is connected to a Faraday mirror 15 (FRM). Preferably the optical fibre cable 10 and the two cables 11 are coated in a covering 16 acting as an electrical insulator and containment for the cables positioned close together.

In an alternative embodiment of the present invention, the electrical conductor cables 17 made of copper for example, instead of being side by side, are wound and twisted around the optical fibre cable 10. In this case the Faraday mirror (FRM) 15 is not essential.

The cable 10, which represents the voltage sensor, is positioned between the two conducting cables 11 or the two conducting cables 17 so that they are within the electric field generated by the conducting cables 11 and 17.

In another embodiment of the present invention, an optical fibre cable 20, terminating in a Faraday mirror (FRM) 28, is positioned in the vicinity of an insulator 21 of a high voltage pylon 22, where a high voltage cable 24 is present.

In this case, due to the high voltage present (greater than 30KV) the copper cables 11 or 17 are not necessary since the electric field E generated between the high voltage cable 24 and the end of the insulator 21, which is connected to the pylon 22, is sufficiently high to directly measure with the optical fibre cable 20 the drop in voltage.

Therefore the cables 11, the cables 17 and the electrically conductive elements 24 and 22 form two electric terminals which if energized form an electric field between them, and the optical fibre sensors 10, 20 positioned between them allow measurement of the voltage present between the ends of the two electrical terminals.

The cable 10, and the cable 20 made of optical fibre, which represent the voltage sensor, associated with the two cables 11 or the two cables 17, or alone in the vicinity of the insulator 21, can be arranged linearly for a predetermined length or, in the case of very long lengths, can be wound on themselves creating a coil 27. The optical fibre cable 13, which represents a means of connection of the optical fibre cable 10 or 20 (sensor), can be of any length since it does not affect the measurements taken.

The optical fibre cable 10, 13 and 20 is a cable containing a standard optical fibre for telecommunications, for example the single-mode fibre (SSMF) in compliance with the ITU-T G.652 recommendation. Therefore the cable does not require the use of special fibres to maintain the polarization (PM, Panda, Hi-Bi and Low-Bi).

The Faraday mirror 15 is a Faraday rotator mirror, where the state of polarization (SOP) of the reflected light is rotated 90° with respect to the incident light.

In an embodiment variation, it is possible to associate the cable 10, 13 and 20 as previously described with a reference optical fibre cable 30, terminating in a Faraday mirror 31, which is inserted in the same covering 16.

The reference fibre 30 can be positioned externally with respect to the electric conductors and therefore is not affected by the field E and the Kerr effect. In this way the reference fibre 30 is able to compensate for any mechanical vibrations induced not only along the connecting section but also on the sensor hybrid cable but without influencing the voltage measurement.

To compensate for the mechanical vibrations, the common mode signal present in the measuring fibres and in the reference fibre is eliminated.

The optical transmitter and receiver 14 comprises an optical source 40 which provides an optical signal to a coupler 41 (3x3) which is connected, on the other side, to the fibre 10 and if necessary to the optical fibre 30.

The optical source 40 provides an optical signal at a length of 1550 nm, but other wavelengths can be used. The coupler 41 is further connected to the photodiodes 42 for optical/electrical conversion of the optical signals received. The coupler 41 and the photodiodes 42 provide a phase diversity coherent reception system, as described in the patent application WO2013179118A1. Only through "a phase diversity" coherent system is it possible to recover, in a completely passive manner, the in-phase 43 and quadrature 44 components of the optical signal received, which are then sent to an electronic board 45.

The electronic board 45 houses a digital analog converter for each electric component 43 and 44 received, and a processor which receives the digital electric signals coming from the converters. Starting from the digitalized components 43 and 44 of the optical signal, via an appropriate and ultra-fast digital processing in the electrical domain, it is possible to reconstruct the time and spectral evolution of the phase of the optical field and subsequently obtain the information relative to the voltage measurement.

With the present invention, the cable 10 (sensor) inserted in the flat cable 11 or in the twisted cable 17 is able to provide, simultaneously with the voltage measurement, also information on the local temperature in the hybrid cable. Knowing the dependence of the Kerr effect on T and the actual temperature in the cable, it is possible, via appropriate digital processing by means of the digital processor present in the electronic board 45, to recalibrate in real time the response of the cable 10.

The temperature information can be extracted using different reading modes.

With reference to the phase diversity coherent detection scheme, with an appropriate unbalance $\Delta L$ between the reference and measurement branches and the introduction of a modulation of the optical carrier $\Delta v$, it is possible to extrapolate the value of the absolute temperature T in the cable from the measurement of the induced phase modulation $\Delta\phi$:

$$\Delta\phi = 4\pi n \Delta L \frac{\Delta v}{c} + 4\pi L \frac{\Delta v}{c}\left(\frac{n}{L}\frac{dL}{dT} + \frac{dn}{dT}\right)T$$

where $dL/(LdT) = 5\cdot10^{-7}$ K$^{-1}$ $dn/dT = 10^{-5}$ K$^{-1}$.

Alternatively to what has been previously described for measurement of the temperature, a distributed Bragg reflector 51 can be inserted in the sensor fibre 10.

Variations $\Delta T$ in the local temperature induce a shift in the transmission spectrum of the distributed Bragg reflector 51 (centred at the wavelength $\lambda 2$ of a laser source) and consequently a variation $\Delta I_0$ in the intensity of the retroreflected signal.

In this case a WDM (wavelength division multiplexing) approach is adopted using two distinct wavelengths, $\lambda 1$ and $\lambda 2$, one for measurement of the phase $\Delta\phi$ induced by the Kerr effect and one for the measurement of $\Delta I_0$ induced by temperature variations. The separation of the two wavelengths is obtained by inserting a WDM filter 52 on the measurement/signal branch, downstream of the coupler 41.

The device therefore comprises a laser source 40 at $\lambda 1$ (for example at 1550 nm) connected to the coupler 41 and another laser source 55 at $\lambda 2$ (for example at 1535 nm) connected to a circulator 56. Coupler 41 and circulator 56 are coupled to the WDM filter 52 which is connected to the fibre 10.

Another terminal of the circulator 56 is connected to a receiver 57 for measurement of the intensity variations $\Delta I_0$ of the signal at $\lambda 2$.

The transmission function of the distributed Bragg reflector 51 and the resolution of the acquisition system shall be selected in such a way as to guarantee, in the range of the temperature T, a sufficient sensitivity in the measurement of $\Delta T$.

What is described can also be applied to the version of the sensor with copper cables 17 wound and twisted around the optical fibre cable 10, and also for high voltage measurements.

Operation of the invention appears evident to a person skilled in the art from what has been described and in particular is the following.

The sensor proposed is able to provide a measurement of $\Delta\phi$ and therefore of the voltage V in the vicinity of the fibre 10, independent of the random orientation of the SOP of the optical signal with respect to the direction of the field E applied, as in the following formulas.

$$\Delta\phi = \beta \cdot L \cdot \Delta n$$

where $\beta = 2\pi n/\lambda$ ($\lambda = 1550$ nm and n=1.45) and

$$\Delta n = \frac{|E|^2}{2\eta}(2bn_{2K} - n_{2E})$$

and

$$E = V/d$$

Typically the entity of the phase shift $\Delta\phi$ induced by Kerr effect is influenced, via the coefficient b, by the SOP of the optical signal which, varying at random along the standard optical fibre 10, does not allow a deterministic measurement of $\Delta\phi$ and therefore of the voltage applied V.

The use of a Faraday mirror 15, on the other hand, due to rotation of the state of polarization, allows complete retracing of the SOP reflected throughout the optical fibre cable 10. In this way the output and orthogonal input SOP guarantee a $\Delta\phi$ which is always averaged on the two extreme values (1 and 1/3) of the parameter b and therefore a deterministic measurement of the voltage V.

The use of a Faraday mirror 15 furthermore allows stabilization of the SOP of the retroreflected signal at the input to the coherent demodulation system, as required for example in a phase diversity detection scheme.

Alternatively to the use of the Faraday mirror 15, the copper cables 17 can be used wound and twisted around the optical fibre cable 10, with a periodically alternate orientation along the length of the fibre. This guarantees a measurement of the Kerr effect spatially averaged over several relative orientations between the SOP of the signal and the electric field E, thus minimizing the dependence of the Kerr effect on the random SOP of the optical signal. The smaller the pitch of the electric conductor winding, compatibly with production restrictions, the more effective the resulting effect.

In particular, the twisted cable 17 not using a Faraday mirror (FRM) to compensate the dependence of the Kerr effect on the polarization can be used for configurations in transmission or for configurations in reflection that require conventional reflecting systems like mirrors or distributed Bragg reflectors (FBG).

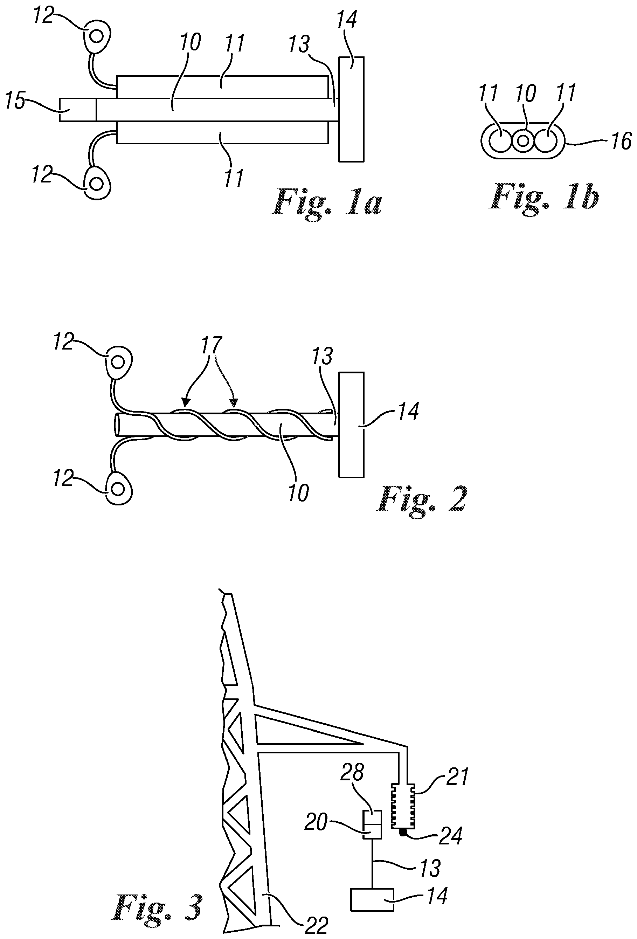

In the case of measurement of the power supply voltage of industrial machinery (V = 220V), since the voltage values are relatively low, it is necessary to arrange the sensor fibre longitudinally between two live (insulated) electric conductors, arranged as close as possible to the fibre coating, over a distance L, producing a sort of hybrid cable as shown in figure 1 or figure 2.

In this way a sufficiently high electric intensity E is generated which, integrated over the whole distance L, allows an integral Kerr effect to be induced sufficient also for measuring modest voltages.

If a hybrid cable is used, or a sensor fibre, with length L=1 m and assuming a coating of the optical fibre d =250 $\mu$m and a voltage V= 220V applied at the terminals of the conductors, a field E=V/d = 0,88 kV/mm applied along the fibre is obtained, with a consequent induced phase shift

$$\Delta\phi = \beta \cdot L \cdot \Delta n$$

where $\beta=2\pi\eta/\lambda$ ($\lambda$ =1550 nm and n=1,45) and

$$\Delta n = \frac{|E|^2}{2\eta}(2bn_{2K} - n_{2E})$$

with b= 2/3 (mean value of the two extreme values of b). By substituting the values, a phase shift of $\Delta\phi$= 0,15 mrad is obtained.

In the case of monitoring of the presence of electric field in the vicinity of the insulators in the high voltage (HV) electrical distribution lines, like for example a HV line with V = 330 kV, the value of the electric field E in the vicinity of the insulator is typically in the range 0,5kV/mm - 2kV/mm (the EPRI regulations recommend design of the insulators so as to guarantee an electric field limit value E of 0,45 kV/mm).

If an optical fibre coil with length L=1 m (diameter D= 6 cm) is positioned near (a few centimetres) the live terminal of the insulator where a field E = 1kV/mm is assumed, the phase shift $\Delta\phi$ induced by Kerr effect is equal to $\Delta\phi$= 0,2 mrad, a phase value that can be easily measured with a coherent reading system.

**Claims**

1.  A voltage measuring system with an optical fibre cable comprising:

    a first electric terminal (11, 17, 24); and a second electric terminal (11, 17, 22); an optical fibre cable (10, 20) positioned in the electric field formed between said first (11, 17, 24) and said second terminal (11, 17, 22); a laser source (40) which provides an optical signal to said optical fibre cable (10, 20); means (15, 28) for rotating the state of polarization (SOP) of the optical signal passing through said optical fibre cable (10, 20); a coherent receiver (41, 42) to receive a reflected optical signal coming from said optical fibre cable (10, 20) and measure the electric voltage present between said first terminal (11, 17, 24) and said second terminal (11, 17, 22), by measuring the phase shift $\Delta\phi$ induced in said optical fibre cable (10, 20) due to electro-optic Kerr effect by the voltage applied between said first electric terminal (11, 17, 24) and said second electric terminal (11, 17, 22); **characterized in that** it comprises means for measuring the temperature of said optical fibre cable(10, 20), wherein the measured temperature is used to compensate in real time the dependence of the Kerr effect on temperature variations.

2. The system according to claim 1 **characterized in that** said means (15, 28) to rotate the state of polarization (SOP) of the optical signal passing through said optical fibre cable (10, 20) comprise a Faraday mirror (15) positioned at the end of said optical fibre cable (10, 20).

3. The system according to claim 2 **characterized in that** said first (11, 17, 24) and said second terminal (11, 17, 22) comprise copper cables (11).

4. The system according to one of the preceding claims **characterized in that** said means (15, 28) to rotate the state of polarization (SOP) of the optical signal passing through said optical fibre cable (10) comprise copper cables (17) wound and twisted around said optical fibre cable (10, 20).

5. The system according to one of the preceding claims **characterized in that** said optical fibre cable (10, 20) is positioned between a high voltage cable (24) and a pylon (22).

6. The system according to one of the preceding claims **characterized in that** said optical fibre cable (10, 20) is wound to form a coil (27).

7. The system according to one of the preceding claims **characterized in that** said optical fibre cable (10, 20) is associated with a reference optical fibre cable (30), terminating in a Faraday mirror (31), and positioned externally to the electric field formed between said first (11, 17, 24) and second terminal (11, 17, 22).

8. The system according to one of the preceding claims **characterized in that** said coherent receiver (41, 42) provides the phase component (43) and the quadrature component (44) of said reflected optical signal to an electronic board (45) which provides the voltage value present between said first terminal (11, 17, 24) and said second terminal (11, 17, 22).

9. The system according to one of the preceding claims **characterized in that** it comprises a reference fibre cable (30) that is positioned externally respect to the electric conductors to compensate for any mechanical vibration by eliminating the common mode signal present in the measuring fibre and in the reference fibre.

10. A voltage measuring method with optical fibre cable comprising the steps of: positioning an optical fibre cable (10, 20) in the electric field formed between a first (11, 17, 24) and a second terminal (11, 17, 22); providing an optical signal to said optical fibre cable (10, 20); rotating the state of polarization (SOP) of the optical signal passing through said optical fibre cable (10, 20); receiving a reflected optical signal coming from said optical fibre cable (10, 20), by means of a coherent receiver (41, 42); measuring the electric voltage present between said first terminal (11, 17, 24) and said second terminal (11, 17, 22) by measuring the phase shift $\Delta\phi$ induced in said optical fibre cable (10, 20) due to electro-optic Kerr effect by the voltage applied between said first electric terminal (11, 17, 24) and said second electric terminal (11, 17, 22); **characterized by** comprising the step of measuring the temperature of said optical fibre cable (10, 20), wherein the measured temperature is used to compensate in real time the dependence of the Kerr effect on temperature variations.

**Patentansprüche**

1. Ein Stromspannungsmess-System mit einem Lichtwellenleiterkabel, welches eine elektrische Anschlussklemme (11, 17, 24) umfasst; sowie eine zweite elektrische Anschlussklemme (11, 17, 22); ein Lichtwellenleiterkabel (10, 20), das sich im elektrischen Feld befindet, welches zwischen der genannten ersten (11, 17, 24) und der genannten zweiten Anschlussklemme (11, 17, 22) gebildet wird; eine Laserquelle (40), die ein optisches Signal an das genannte Lichtwellenleiterkabel (10, 20) liefert; Elemente (15, 28) zur Drehung des Polarisationszustands (SOP) des optischen Signals, das durch das genannte Lichtwellenleiterkabel (10, 20) führt; einen kohärenten Empfänger (41, 42), um ein reflektiertes optisches Signal zu empfangen, das von dem genannten Lichtwellenleiterkabel (10, 20) stammt und die Stromspannung zu messen, welche zwischen der genannten ersten Anschlussklemme (11, 17, 24) und der

EP 3 602 092 B1

genannten zweiten Anschlussklemme (11, 17, 22) vorhanden ist, und zwar durch die Messung der Phasenverschiebung $\Delta\phi$, die in diesem Lichtwellenleiterkabel (10, 20) infolge des elektro-optischen Kerr-Effekts durch die Stromspannung verursacht wird, welche zwischen der genannten ersten Anschlussklemme (11, 17, 24) und der genannten zweiten Anschlussklemme (11, 17, 22) angelegt wird; **dadurch gekennzeichnet, dass** es Elemente zur Messung der Temperatur des genannten Lichtwellenleiterkabels (10, 20) umfasst, wobei die gemessene Temperatur verwendet wird, um in Echtzeit die Abhängigkeit des Kerr-Effekts von Temperaturschwankungen auszugleichen.

2. Das System gemäß Anspruch 1, **dadurch gekennzeichnet, dass** die genannten Elemente (15, 28), um den Polarisationszustand (SOP) des optischen Signals zu drehen, welches durch das genannte Lichtwellenleiterkabel (10, 20) hindurch führt, einen Faraday-Spiegel (15) umfassen, der am Ende des genannten Lichtwellenleiterkabels (10, 20) angeordnet ist.

3. Das System gemäß Anspruch 2, **dadurch gekennzeichnet, dass** die genannte erste (11, 17, 24) und die genannte zweite Anschlussklemme (11, 17, 22) jeweils Kupferkabel (11) umfassen.

4. Das System gemäß einem beliebigen der vorausgegangenen Ansprüche, **dadurch gekennzeichnet, dass** die genannten Elemente (15, 28), um den Polarisationszustand (SOP) des optischen Signals zu drehen, welches durch das genannte Lichtwellenleiterkabel (10) hindurch führt, Kupferkabel (17) umfassen, die um das genannte Lichtwellenleiterkabel (10, 20) gewunden und gewickelt sind.

5. Das System gemäß einem beliebigen der vorausgegangenen Ansprüche, **dadurch gekennzeichnet, dass** das genannte Lichtwellenleiterkabel (10, 20) jeweils zwischen einem Hochspannungskabel (24) und einem Leitungsmast (22) angeordnet ist.

6. Das System gemäß einem beliebigen der vorausgegangenen Ansprüche, **dadurch gekennzeichnet, dass** das genannte Lichtwellenleiterkabel (10, 20) so gewickelt ist, dass es eine Spule (27) bildet.

7. Das System gemäß einem beliebigen der vorausgegangenen Ansprüche, **dadurch gekennzeichnet, dass** das genannte Lichtwellenleiterkabel (10, 20) jeweils mit einem Referenz-Lichtwellenleiterkabel (30) verbunden ist, welches in einem Faraday-Spiegel (31) endet und außerhalb des elektrischen Felds angeordnet ist, das jeweils zwischen der genannten ersten (11, 17, 24) und der genannten zweiten Anschlussklemme (11, 17, 22) angeordnet ist.

8. Das System gemäß einem beliebigen der vorausgegangenen Ansprüche, **dadurch gekennzeichnet, dass** der genannte kohärente Empfänger (41, 42) die Phasenkomponente (43) und die Quadraturkomponente (44) des genannten reflektierten optischen Signals an eine elektronische Platine (45) liefert, welche den Spannungswert liefert, der jeweils zwischen der genannten ersten Anschlussklemme (11, 17, 24) und der genannten zweiten Anschlussklemme (11, 17, 22) vorhanden ist.

9. Das System gemäß einem beliebigen der vorausgegangenen Ansprüche, **dadurch gekennzeichnet, dass** es ein Referenz- Lichtwellenleiterkabel (30) umfasst, welches außen in Bezug auf die elektrischen Leiter angeordnet ist, um etwaige mechanische Vibrationen durch Eliminierung des Gleichtaktsignals auszugleichen, das in der Messfaser und der Referenzfaser vorhanden ist.

10. Ein Stromspannungs-Messverfahren mit Lichtwellenleiterkabel, das jeweils folgende Schritte umfasst: die Anordnung eines Lichtwellenleiterkabels (10, 20) im elektrischen Feld, das jeweils zwischen der ersten (11, 7, 24) und der zweiten (11, 17, 22) Anschlussklemme gebildet wird; die Lieferung eines optischen Signals an das genannte Lichtwellenleiterkabel (10, 20); die Drehung des Polarisationszustands (SOP) des optischen Signals, das durch das genannte Lichtwellenleiterkabel (10, 20) führt; den Empfang eines reflektierten optischen Signals, welches von dem genannten Lichtwellenleiterkabel (10, 20) stammt, und zwar durch einen kohärenten Empfänger (41, 42); die Messung der Stromspannung, die zwischen der genannten ersten Anschlussklemme (11, 17, 24) und der genannten zweiten Anschlussklemme (11, 17, 22) vorhanden ist, durch die Messung der Phasenverschiebung $\Delta\phi$, welche in dem genannten Lichtwellenleiterkabel (10, 20) infolge des elektro-optischen Kerr-Effekts durch die Spannung verursacht wird, die zwischen der genannten ersten elektrischen Anschlussklemme (1, 17, 24) und der genannten zweiten elektrischen Anschlussklemme (11, 17, 22) angelegt wird; **dadurch gekennzeichnet, dass** es den Schritt der Messung der Temperatur des genannten Lichtwellenleiterkabels (10, 20) umfasst,
wobei die jeweils gemessene Temperatur verwendet wird, um in Echtzeit die Abhängigkeit des Kerr-Effekts von Temperaturschwankungen auszugleichen.

**Revendications**

1. Système de mesure de tension avec un câble à fibres optiques comprenant:

une première borne électrique (11, 17, 24); et une deuxième borne électrique (11, 17, 22); un câble à fibres optiques (10, 20) positionné dans le champ électrique formé entre ladite première (11, 17, 24) et ladite deuxième bornes (11, 17, 22); une source laser (40) qui fournit un signal optique audit câble à fibres optiques (10, 20); des moyens (15, 28) pour tourner l'état de polarisation (SOP) du signal optique passant à travers ledit câble à fibres optiques (10, 20); un récepteur cohérent (41, 42) pour recevoir un signal optique réfléchi venant dudit câble à fibres optiques (10, 20) et mesurer la tension électrique présente entre ladite première borne (11, 17, 24) et ladite deuxième borne (11, 17, 22), en mesurant le déphasage $\Delta\phi$ induit dans ledit câble à fibres optiques (10, 20) à cause d'un effet Kerr électro-optique par la tension appliquée entre ladite première borne électrique (11, 17, 24) et ladite deuxième borne électrique (11, 17, 22); **caractérisé en ce qu'**il comprend des moyens de mesure de la température dudit câble à fibres optiques (10, 20), où la température mesurée est utilisée pour compenser en temps réel la dépendance de l'effet Kerr sur des variations de température.

2. Système selon la revendication 1, **caractérisé en ce que** lesdits moyens (15, 28) pour tourner l'état de polarisation (SOP) du signal optique passant à travers ledit câble à fibres optiques (10, 20) comprennent un miroir de Faraday (15) positionné à l'extrémité dudit câble à fibres optiques (10, 20).

3. Système selon la revendication 2, **caractérisé en ce que** ladite première (11, 17, 24) et ladite deuxième bornes (11, 17, 22) comprennent des câbles en cuivre (11).

4. Système selon l'une des revendications précédentes, **caractérisé en ce que** lesdits moyens (15, 28) pour tourner l'état de polarisation (SOP) du signal optique passant à travers ledit câble à fibres optiques (10) comprennent des câbles en cuivre (17) enroulés et torsadés autour dudit câble à fibres optiques (10, 20).

5. Système selon l'une des revendications précédentes, **caractérisé en ce que** ledit câble à fibres optiques (10, 20) est positionné entre un câble à haute tension (24) et un pylône (22).

6. Système selon l'une des revendications précédentes, **caractérisé en ce que** ledit câble à fibres optiques (10, 20) est enroulé pour former une bobine (27).

7. Système selon l'une des revendications précédentes, **caractérisé en ce que** ledit câble à fibres optiques (10, 20) est associé avec un câble à fibres optiques de référence (30), se terminant en un miroir de Faraday (31), et positionné à l'extérieur du champ électrique formé entre ladite première (11, 17, 24) et ladite deuxième bornes (11, 17, 22).

8. Système selon l'une des revendications précédentes, **caractérisé en ce que** ledit récepteur cohérent (41, 42) fournit la composante en phase (43) et la composante en quadrature (44) dudit signal optique réfléchi à une carte électronique (45) qui fournit la valeur de tension présente entre ladite première borne (11, 17, 24) et ladite deuxième borne (11, 17, 22).

9. Système selon l'une des revendications précédentes, **caractérisé en ce qu'**il comprend un câble à fibres de référence (30) qui est positionné à l'extérieur par rapport aux conducteurs électriques pour compenser toute vibration mécanique en éliminant le signal de mode commun présent dans la fibre de mesure et dans la fibre de référence.

10. Procédé de mesure de tension avec un câble à fibres optiques comprenant les étapes de: positionnement d'un câble à fibres optiques (10, 20) dans le champ électrique formé entre une première (11, 17, 24) et une deuxième bornes (11, 17, 22); fourniture d'un signal optique audit câble à fibres optiques (10, 20); rotation de l'état de polarisation (SOP) du signal optique passant à travers ledit câble à fibres optiques (10, 20); réception d'un signal optique réfléchi venant dudit câble à fibres optiques (10, 20), au moyen d'un récepteur cohérent (41, 42); mesure de la tension électrique présente entre ladite première borne (11, 17, 24) et ladite deuxième borne (11, 17, 22) en mesurant le déphasage $\Delta\phi$ induit dans ledit câble à fibres optiques (10, 20) à cause d'un effet Kerr électro-optique par la tension appliquée entre ladite première borne électrique (11, 17, 24) et ladite deuxième borne électrique (11, 17, 22); **caractérisé en ce qu'**il comprend l'étape de mesure de la température dudit câble à fibres optiques (10, 20), où la température mesurée est utilisée pour compenser en temps réel la dépendance de l'effet Kerr sur les variations de température.

Fig. 1a

Fig. 1b

Fig. 2

Fig. 3

*Fig. 4*

*Fig. 5*

*Fig. 6*

*Fig. 7*

**Fig. 8**

**Fig. 9**

**EP 3 602 092 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5994898 A
- US 5631559 A
- US 5493220 A
- WO 2013179118 A1